# EUROPEAN PATENT APPLICATION

(11) **EP 4 371 854 A1**
(43) Date of publication of application: **22.05.2024**
(21) Application number: 21949562.9
(22) Date of filing: 12.07.2021
(51) Int. Cl.: B62D 5/06, B62D 5/04, B60R 16/02, H03K 17/687

(54) **POWER SOURCE CONTROL CIRCUIT AND POWER STEERING SYSTEM**

(71) Applicant: Schaeffler Technologies AG & Co. KG, 91074 Herzogenaurach (DE)
(72) Inventor: YU, Sheng, Shanghai 201800 (CN); ZHANG, Xiaoliang, Kunshan, Jiangsu 215332 (CN)
(86) International application number: PCT/CN2021/105774
(87) International publication number: WO 2023/283764

(57) **Abstract**

A power source control circuit (300) and a power steering system (500). The power source control circuit (300) comprises: a signal input circuit (310), which comprises at least two input ends, wherein each of the at least two input ends is used for collecting a first control signal, which indicates whether an external device corresponding to the input end is abnormal; and a control circuit (330), which is used for generating, according to the first control signals collected by each of the at least two input ends, a second control signal, which is used for controlling the turning-off of a power source (520).

## Description

### Technical Field

The present invention relates to the field of power source control, and in particular relates to a power source control circuit and a power steering system.

### Background

A steering system is an important constituent part of a vehicle, and the performance of the steering system directly affects the stability and safety of the vehicle. In the related art, a power steering system applied to a vehicle may comprise an electric-hydraulic power steering system (EHPS for short). For the vehicle using the EHPS, the EHPS is one of components and parts with the highest level of requirements for the safety of the entire vehicle. In order to meet high standard requirements of vehicles such as commercial vehicles for power steering, it is necessary to increase the reliability of the EHPS.

Due to functional safety requirements for the EHPS, a power supply circuit of a motor (hereinafter referred to as a "steering motor") used for providing steering assisting power is a safety-related path, and when a fault in an external device is detected, electric power supplied to the steering motor must be cut off, that is, a power source for supplying electric power to the steering motor must be turned off. Hard turning-off can be performed by detecting faults of three components: a microprocessor chip, a power source management chip and a pre-driver chip.

### Summary

The present invention aims to overcome or at least alleviate the foregoing deficiency in the above-mentioned prior art, and provides a power source control circuit and a power steering system.

According to an aspect of the present invention, a power source control circuit is provided, comprising: a signal input circuit, which comprises at least two input ends, wherein each of the at least two input ends is used for collecting a first control signal, which indicates whether an external device corresponding to the input end is abnormal; and a control circuit, which is used for generating, according to the first control signals collected by each of the at least two input ends, a second control signal, which is used for controlling the turning-off of a power source.

For the above-mentioned power source control circuit, in one possible implementation, the control circuit generates the second control signal when the first control signal collected by at least one of the at least two input ends indicates that the external device corresponding to the input end is abnormal.

For the above-mentioned power source control circuit, in one possible implementation, the control circuit generates a third control signal used for maintaining the turning-on of the power source when the first control signals collected by each of the at least two input ends all indicate that the external devices corresponding to the input ends are normal.

For the above-mentioned power source control circuit, in one possible implementation, the first control signal indicates that the external device corresponding to the input end is abnormal when the first control signal collected by the input end satisfies the first predetermined condition; and the first control signal indicates that the external device corresponding to the input end is normal when the first control signal does not satisfy the first predetermined condition, wherein the first predetermined condition comprises: a level value to which the first control signal corresponds is lower than a predetermined level value, or the level value to which the first control signal corresponds is within a preset level range.

For the above-mentioned power source control circuit, in one possible implementation, the first control signal indicates that the external device corresponding to the input end is abnormal when the first control signal collected by the input end satisfies the first predetermined condition; and the first control signal indicates that the external device corresponding to the input end is normal when the first control signal does not satisfy the first predetermined condition, wherein the first predetermined condition comprises: a level value to which the first control signal corresponds is higher than a predetermined level value, or a level value to which the first control signal corresponds is within a preset level range.

For the above-mentioned power source control circuit, in one possible implementation, the at least two input ends comprise a first input end and at least one second input end, and the control circuit comprises at least two input OR gates, wherein the first input end is connected to one input terminal of the at least two input OR gates via a first resistor, each of the at least one second input end is connected to a corresponding input terminal of remaining input terminals of the at least two input OR gates via a diode, and output ends of the at least two input OR gates are used for outputting the second control signal used for controlling the turning-off of the power source, or the third control signal used for maintaining the turning-on of the power source.

The above-mentioned power source control circuit, in one possible implementation, further comprises: a switch circuit, connected to the output ends of the at least two input OR gates, and used for turning off or turning on the power source according to control signals generated by the control circuit, wherein the switch circuit turns off the power source when the control circuit generates the second control signal, and the switch circuit turns on the power source when the control circuit generates the third control signal used for maintaining the turning-on of the power source.

For the above-mentioned power source control circuit, in one possible implementation, the switch circuit comprises: a second resistor and a third resistor, wherein the second resistor and the third resistor are connected in series between the output ends of the at least two input OR gates and a ground terminal; a first transistor, wherein a base of the first transistor is connected to a connection point between the second resistor and the third resistor, and an emitter of the first transistor is connected to the ground terminal; a fourth resistor, a fifth resistor and a second transistor, wherein the fourth resistor is connected between a collector of the first transistor and a base of the second transistor, the fifth resistor is connected between the fourth resistor and an emitter of the second transistor, and a connection point between the fifth resistor and the emitter of the second transistor is connected to an output end of a boost circuit; and a sixth resistor and an MOS tube, wherein the sixth resistor is connected between a control end of the MOS tube and a collector of the second transistor, an input end of the MOS tube is connected to the power source, and an output end of the MOS tube is connected to a voltage output end used for detecting the turning-on and turning-off of the power source.

For the above-mentioned power source control circuit, in one possible implementation, the switch circuit further comprises a seventh resistor and a Zener diode, wherein the seventh resistor and the Zener diode are connected in parallel between the output end of the MOS tube and a connection point between the collector of the second transistor and the sixth resistor.

For the above-mentioned power source control circuit, in one possible implementation, the switch circuit further comprises: a ninth resistor and a tenth resistor, wherein the ninth resistor and the tenth resistor are connected in series between the ground terminal and the connection point between the collector of the second transistor and the sixth resistor; an eleventh resistor and a third capacitor, wherein the eleventh resistor and the third capacitor are connected in series between the ground terminal and a connection point between the ninth resistor and the tenth resistor; and a gate voltage detection end, wherein the gate voltage detection end is connected to a connection point between the eleventh resistor and the third capacitor.

According to another aspect of the present invention, a power steering system is provided, comprising: a motor, used for providing steering assisting power; a power source, used for supplying electric power to the motor; and the above-mentioned power source control circuit, used for controlling the turning-off or turning-on of the power source.

The power source control circuit according to the present invention comprises: a signal input circuit, which comprises at least two input ends, and a control circuit, which is connected to the signal input circuit, wherein the control circuit can generate, according to first control signals which are collected by each of the at least two input ends of the signal input circuit and indicate whether external devices corresponding to the input ends are abnormal, a second control signal, which is used for controlling the turning-off of the power source, thereby controlling the turning-off of the power source based on the second control signal generated according to the first control signals collected by each of the at least two input ends. Hence, compared with the prior art which can only achieve single-channel fault control, the present invention can achieve multi-channel fault control.

Other features and aspects of the present invention will become clear according to the following detailed descriptions of exemplary embodiments with reference to drawings.

### Brief Description of the Drawings

The drawings included in the specification and constituting a part thereof together with the specification illustrate exemplary embodiments, features, and aspects of the present invention, and are used to explain the principles of the present invention.
FIG. 1 is a structural diagram of a power source control circuit in the related art.
FIG. 2 is a schematic diagram of a power source control circuit shown according to an exemplary embodiment.
FIG. 3 is a structural diagram of the power source control circuit shown according to an exemplary embodiment.
FIG. 4 is a schematic diagram of on-off control of a power source switching from a high level to a low level in an embodiment of the present invention.
FIG. 5 is a schematic diagram of on-off control of a power source switching from a high level to a low level in an embodiment of the present invention.
FIG. 6 is a schematic diagram of on-off control of a power source switching from a high level to a low level in an embodiment of the present invention.
FIG. 7 is a structural diagram of a power steering system shown according to an exemplary embodiment.

### Detailed Description

Various exemplary embodiments, features and aspects of the present invention will be described in detail below with reference to the drawings. The same reference numerals in the drawings indicate elements with the same or similar functions. Although various aspects of the embodiments are shown in the drawings, the drawings are not necessarily drawn to scale unless otherwise specified.

The dedicated word "exemplary" herein means "serving as an example, embodiment, or being illustrative". Any embodiment described herein as "exemplary" is not necessarily construed as being superior to or better than other embodiments.

In addition, in order to better illustrate the present invention, numerous specific details are given in the following specific embodiments. Those skilled in the art will understand that the present invention can also be implemented without certain specific details. In some other examples, the methods, means, elements and circuits that are well known to those skilled in the art have not been described in detail, so as to highlight the gist of the present invention.

Referring to the preceding part of the text, due to functional safety requirements for an EHPS, a power supply circuit of a motor (i.e., a steering motor) used for providing steering assisting power is a safety-related path, and when faults of corresponding components, such as a microprocessor chip, a power source management chip and a pre-driver chip, are detected, a power source for supplying electric power to the steering motor needs to be turned off. In other words, it is necessary to provide a control circuit for achieving turning-off control of the aforementioned power source.

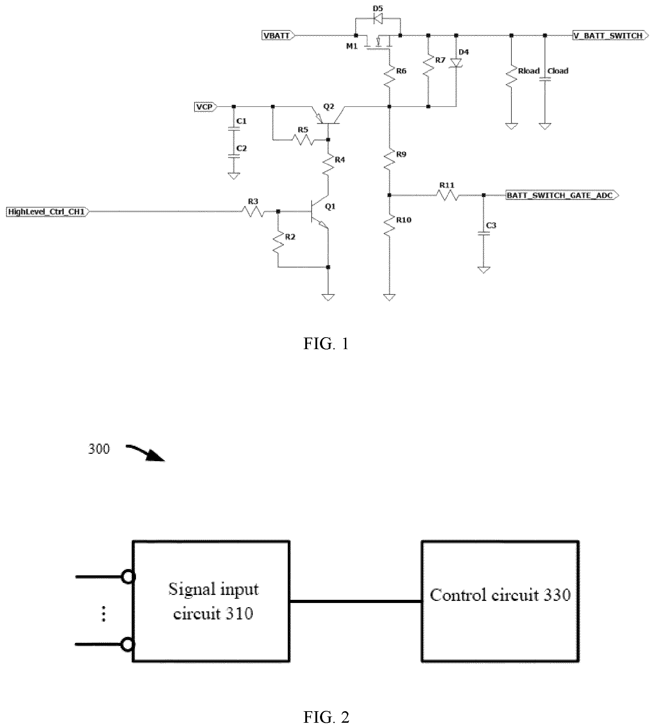

In the related art, a single-channel control circuit is used for achieving turning-off control of a power source, wherein when a fault is detected, a voltage of the single-channel control circuit is switched from a high level to a low level to turn off the power source used for supplying electric power to the steering motor. The aforementioned related art will be described in detail below with reference to FIG. 1.

FIG. 1 is a structural diagram of a power source control circuit in the related art. Referring to FIG. 1, the power source control circuit comprises a HighLevel_Ctrl_CH1 terminal, resistors R2-R11, a resistor Rload, transistors Q1-Q2, an N-channel MOSFET M1, a Zener diode D4, capacitors C1-C3, a load capacitor Cload, a diode D5, a VBATT terminal, a VCP terminal, a V_BATT_SWITCH terminal and a BATT_SWITCH_GATE_ADC terminal. For the convenience of description, the power source control circuit shown in FIG. 1 is divided into a signal input circuit, a first control circuit and a second control circuit herein.

Still referring to FIG. 1, the signal input circuit of the power source control circuit only comprises one input end, i.e., the HighLevel_Ctrl_CH1 terminal. The first control circuit of the power source control circuit comprises the transistors Q1 and Q2. The transistor Q1 is on or off under the combined action of the HighLevel_Ctrl_CH1 terminal and the voltage dividing resistors R2 and R3. An on voltage of the transistor Q2 comes from an output voltage of a boost circuit, that is, a level of the VCP terminal. C1 and C2 are boost charge pump filter capacitors, which are used for filtering a voltage of a boost charge pump. The transistor Q2 is on or off under the action of the voltage dividing resistors R4 and R5.

Still referring to FIG. 1, the second control circuit of the power source control circuit comprises the N-channel MOSFET M1, the diode D5, the reliability resistor R6, the resistor R7, the Zener diode D4, the load resistor Rload and the load capacitor Cload. A source of the NMOS M1 is connected to an anode of the diode D5. A node between a drain of the NMOS M1 and a cathode of the diode D5 is connected to the power source VBATT. A gate of the NMOS M1 is connected to one end of the reliability resistor R6. The diode D5 is a freewheeling diode of the NMOS M1, and is used for absorbing an induced voltage generated by an inductive load. The resistor R7 is used for forming a stable VGS voltage. The Zener diode D4 connected in parallel with the resistor R7 is used for protecting a gate voltage and a source voltage of the NMOS M1 against exceeding a specified limit. A voltage stabilization value of the Zener diode D4 should be less than a maximum voltage value that a voltage difference VGS between the gate voltage and the source voltage of the NMOS M1 can withstand.

Still referring to FIG. 1, the V_BATT_SWITCH terminal is used for detecting the turning-on and/or turning-off of the power source VBATT. When a switch of the MOS tube of the power source VBATT is turned on, a level value of the V_BATT_SWITCH terminal is equal to a voltage of the power source VBATT. Accordingly, when the switch of the MOS tube of the power source VBATT is turned off, a level value of the V_BATT_SWITCH terminal is equal to 0. Therefore, the turning-on and/or turning-off of the power source VBATT can be detected according to the level value of the V_BATT_SWITCH terminal.

More specifically, the level value of the V_BATT_SWITCH terminal can be obtained to determine whether the obtained level value is equal to the voltage of the power source VBATT. If the obtained level value is equal to the voltage of the power source VBATT, it is detected that the power source VBATT is turned on. Accordingly, if the obtained level value is not equal to the voltage of the power source VBATT, but is approximately equal to 0, it is detected that the power source VBATT is turned off.

Still referring to FIG. 1, voltage dividing resistors R9 and R10, a current limiting resistor R11, an RC low-pass filter capacitor C3 and the BATT_SWITCH_GATE_ADC terminal (which is a gate voltage detection end) form a detection circuit for detecting the gate voltage of the NMOS M1. The detection circuit determines whether the gate voltage of the NMOS M1 is successfully loaded based on a level value of the BATT_SWITCH_GATE_ADC terminal.

From FIG. 1, it can be seen that when a level value of the HighLevel_Ctrl_CH1 terminal is a high level, e.g., 5 V, the transistors Q1 and Q2 are on, respectively; and when a voltage between the VCP terminal and the VBATT terminal (that is, a difference between the level values of the two terminals) is greater than an on voltage of the NMOS M1, the NMOS M1 is on, and the power source VBATT is turned on, thereby supplying electric power to the load resistor Rload and the load capacitor Cload.

However, when an abnormality occurs in an external device corresponding to the HighLevel_Ctrl_CH1 terminal, the level value of the HighLevel_Ctrl_CH1 terminal is switched from a high level to a low level, for example, from 5 V to 0 V, the transistors Q1 and Q2 are off, the NMOS M1 is also off, and the power source VBATT is turned off, thereby stopping the supply of electric power to the load resistor Rload (a value of resistance of which is, for example, 180 ohms) and the load capacitor Cload (a capacitance value of which is, for example, 4.8 uF), and further achieving the turning-off control of the power source.

Therefore, the power source control circuit shown in FIG. 1 achieves turning-off control of the power source based on one terminal, i.e., the HighLevel_Ctrl_CH1 terminal, so that the power source control circuit can only achieve single-channel fault control, but cannot achieve multi-channel fault control.

In view of this, embodiments of the present invention provide a power source control circuit that can achieve multi-channel fault control.

FIG. 2 is a schematic diagram of a power source control circuit shown according to an exemplary embodiment. Referring to FIG. 2, the power source control circuit 300 may comprise a signal input circuit 310. The signal input circuit 310 may comprise at least two input ends. Each of the at least two input ends may be used for collecting a first control signal which indicates whether an external device corresponding to the input end is abnormal.

In the present embodiment, each of the at least two input ends comprised in the signal input circuit 310 is an input terminal of the power source control circuit. Each of the at least two input ends may collect the first control signal which indicates whether the external device corresponding to the input end is abnormal. In one possible implementation, whether the external device corresponding to each of the input ends is abnormal can be detected, that is, whether a fault occurs. If it is detected that a fault occurs in the external device corresponding to the input end, the input end can collect the first control signal which indicates that the external device is abnormal. If it is detected that no fault occurs in the external device corresponding to the input end, the input end can collect a control signal which indicates that the external device is normal.

In one possible implementation, the external device corresponding to the input end may comprise but be not limited to a corresponding subsystem of a vehicle. In the present embodiment, the power source control circuit 300 can be applied to the vehicle, and can detect whether a fault occurs in the corresponding subsystem of the vehicle corresponding to each of the input ends. If it is detected that the fault occurs in the corresponding subsystem, the input end to which the corresponding subsystem corresponds can detect the first control signal which indicates that the corresponding subsystem is abnormal.

In the present embodiment, it is noted that a level value of the first control signal collected by the input end when the external device corresponding to the input end is normal is different from a level value of the first control signal collected by the input end when the external device corresponding to the input end is abnormal. In other words, as a state of the external device changes, for example, whether the external device changes from normal to abnormal or from abnormal to normal, the level value of the first control signal collected by the input end also changes accordingly. Therefore, the level value of the first control signal can be used for representing whether the external device corresponding to the input end is abnormal.

In one possible implementation, if the first control signal collected by the input end comprised in the signal input circuit is at a low level, e.g., 0 V, or falls into a low level range, e.g., [0.01 V, 0.30 V], it is indicated that the external device corresponding to the input end is abnormal, that is, a fault occurs in the external device. On the contrary, if the first control signal collected by the input end is at a high level, e.g., 5 V, or falls into a high level range, e.g., [4.9 V, 5.1 V], it is indicated that the external device corresponding to the input end is normal, that is, no fault occurs in the external device.

In one possible implementation, if the first control signal collected by the input end comprised in the signal input circuit 310 is at a high level, e.g., 5 V, or falls into a high level range, e.g., [4.9 V, 5.1 V], it is indicated that the external device corresponding to the input end is abnormal, that is, a fault occurs in the external device. On the contrary, if the first control signal collected by the input end is at a low level, e.g., 0 V, or falls into a low level range, e.g., [0.01 V, 0.30 V], it is indicated that the external device corresponding to the input end is normal, that is, no fault occurs in the external device.

It should be understood that, compared to the power source control circuit in the case that it is indicated that the external device is abnormal when the first control signal is at the low level, the power source control circuit when it is indicated that the external device is abnormal when the first control signal is at the high level further comprises a phase inverter.

The foregoing describes the implementation of the first control signal collected by the input end comprised in the signal input circuit 310 as an example. However, the present invention is not limited thereto. The first control signal collected by the input end comprised in the signal input circuit 310 should also adopt other implementations, and any signal that can represent whether the external device corresponding to the input end is abnormal can be used for implementing the first control signal of the present invention. For example, the first control signal can also be a binary code 1 or 0.

Exemplarily, when the first control signal is the binary code 1, it is indicated that the external device corresponding to the input end is abnormal, that is, a fault occurs in the external device. On the contrary, when the first control signal is the binary code 0, it is indicated that the external device corresponding to the input end is normal, that is, no fault occurs in the external device.

Exemplarily, when the first control signal is the binary code 0, it is indicated that the external device corresponding to the input end is abnormal, that is, a fault occurs in the external device. On the contrary, when the first control signal is the binary code 1, it is indicated that the external device corresponding to the input end is normal, that is, no fault occurs in the external device.

In addition, the power source control circuit 300 of the present embodiment does not specifically restrict a number of the input ends comprised in the signal input circuit 310. Those skilled in the art can select the number of the input ends comprised in the signal input circuit 310 according to actual application requirements, as long as the number of the input ends is greater than or equal to 2, for example, 2, 3, 4 or any other number.

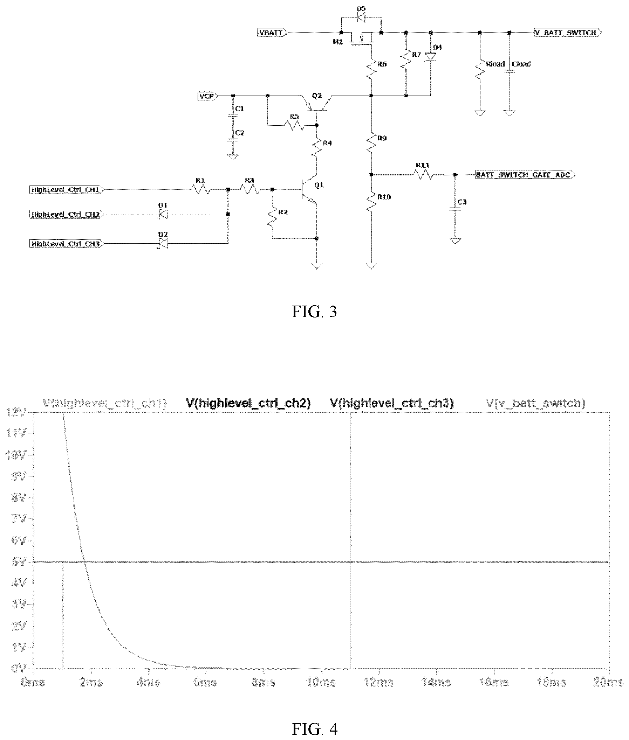

FIG. 3 is a structural diagram of the power source control circuit shown according to an exemplary embodiment. Referring to FIG. 3, the signal input circuit of the power source control circuit comprises a total of 3 input ends: a HighLevel_Ctrl_CH1 terminal, a HighLevel_Ctrl_CH2 terminal and a HighLevel_Ctrl_CH13 terminal. Of course, the signal input circuit may also comprise other numbers of input ends, for example, 2, 4, 5, etc. Due to space limitations, details will not be repeated in the present embodiment.

Still referring to FIG. 2, the power source control circuit 300 may further comprise a control circuit 330, and the control circuit 330 is connected to the signal input circuit 310, and used for generating a second control signal used for controlling the turning-off of the power source according to the first control signals collected by each of the at least two input ends comprised in the signal input circuit 310.

In the present embodiment, the control circuit 330 may generate, according to the first control signals of each of the input ends comprised in the signal input circuit 310, the second control signal by performing corresponding logical operations using a corresponding algorithm, thereby controlling the turning-off of the power source.

In one possible implementation, after the first control signals are collected by each of the input ends comprised in the signal input circuit 310, an OR logical operation can be performed on all the collected first control signals, and a control signal obtained after performing the OR logic operation is used as the second control signal for controlling the turning-off of the power source.

In the present embodiment, the control circuit 330 performing the OR logical operation can naturally generate the second control signal for controlling the turning-off of the power source when the first control signal collected by at least one of the at least two input ends comprised in the signal input circuit 310 indicates that the external device corresponding to the input end is abnormal. Thus, fault control can be performed on multiple external devices using multiple channels, respectively.

The present embodiment does not specifically restrict algorithms used by the control circuit 330 to generate, according to the first control signals, the second control signal. In addition to algorithms corresponding to the OR logical operation, other suitable algorithms may also be used, as long as the second control signal for controlling the turning-off of the power source can be generated according to the first control signal by using the algorithms.

According to the power source control circuit of the present invention, the control circuit can generate, according to the first control signals which are collected by each of the at least two input ends of the signal input circuit and indicate whether the external device corresponding to the input end is abnormal, the second control signal, which is used for controlling the turning-off of the power source. Therefore, the turning-off of the power source can be controlled based on the second control signal generated according to the first control signals collected by each of the at least two input ends. Hence, compared with the prior art which can only achieve single-channel fault control, the present invention can achieve multi-channel fault control.

Moreover, the power source control circuit of the present embodiment has a simple structure and requires a low cost for material consumption. In addition, due to the simple structure and wide applicability of the power source control circuit of the present embodiment, the power source control circuit of the present embodiment is convenient to transplant. Moreover, with changes in actual application requirements, the number of the input ends of the signal input circuit can be changed according to the actual application requirements, for example, the number of external devices to be subject to fault control, without modifying the rest of the circuit structure to meet the application requirements after the changes. Hence, the power source control circuit meeting the actual application requirements can be flexibly configured.

In one possible implementation, the control circuit generates the second control signal when the first control signal collected by at least one of the at least two input ends indicates that the external device corresponding to the input end is abnormal.

In the present embodiment, when at least one of all the first control signals collected by each of the input ends comprised in the signal input circuit indicates that the corresponding external device is abnormal, due to the fact that the fault occurs in the corresponding external device, the power source needs to be turned off. Accordingly, the control circuit generates the second control signal to control the turning-off of the power source.

In one possible implementation, the control circuit generates a third control signal used for maintaining the turning-on of the power source when the first control signals collected by each of the at least two input ends all indicate that the external devices corresponding to the input ends are normal.

In the present embodiment, when all the first control signals collected by each of the input ends comprised in the signal input circuit indicate that the corresponding external devices are normal, due to the fact that no fault occurs in the external devices, the power source does not need to be turned off. Accordingly, the control circuit generates the third control signal to maintain the turning-on of the power source.

In one possible implementation, the first control signal indicates that the external device corresponding to the input end is abnormal when the first control signal collected by the input end satisfies a first predetermined condition; and the first control signal indicates that the external device corresponding to the input end is normal when the first control signal does not satisfy the first predetermined condition, wherein the first predetermined condition comprises: a level value to which the first control signal corresponds is lower than a predetermined level value, or the level value to which the first control signal corresponds is within a preset level range.

In the present embodiment, if the level value to which the first control signal collected by the input end corresponds is lower than a predetermined level value, e.g., 0 V, or the level value to which the first control signal corresponds is within a preset level range, e.g., [0.01 V, 0.30 V], it is indicated that the external device corresponding to the input end is abnormal, that is, a fault occurs in the external device, and at this time, the power source needs to be turned off. Accordingly, if the level value to which the first control signal collected by the input end corresponds is not lower than the predetermined level value, e.g., 0 V, or the level value to which the first control signal corresponds is not within the preset level range, e.g., [0.01 V, 0.30 V], it is indicated that the external device corresponding to the input end is normal, that is, no fault occurs in the external device, and at this time, the power source does not need to be turned off.

In one possible implementation, the first control signal indicates that the external device corresponding to the input end is abnormal when the first control signal collected by the input end satisfies a first predetermined condition; and the first control signal indicates that the external device corresponding to the input end is normal when the first control signal does not satisfy the first predetermined condition, wherein the first predetermined condition comprises: the level value to which the first control signal corresponds is higher than a predetermined level value, or the level value to which the first control signal corresponds is within a preset level range.

In the present embodiment, if the level value to which the first control signal collected by the input end corresponds is higher than a predetermined level value, e.g., 5 V, or the level value to which the first control signal corresponds a preset level range, e.g., [4.9 V, 5.1 V], it is indicated that the external device corresponding to the input end is abnormal, that is, a fault occurs in the external device, and at this time, the power source needs to be turned off. Accordingly, if the level value to which the first control signal collected by the input ends corresponds is not higher than the predetermined level value, e.g., 5 V, or the level value to which the first control signal corresponds is not within the preset level range, e.g., [4.9 V, 5.1 V], it is indicated that the external device corresponding to the input end is normal, that is, no fault occurs in the external device, and at this time, the power source does not need to be turned off.

In one possible implementation, the at least two input ends comprise a first input end, e.g., a HighLevel_Ctrl_CH1 terminal, and at least one second input end, e.g., a HighLevel_Ctrl_CH2 terminal and a HighLevel_Ctrl_CH3 terminal, and the control circuit comprises at least two input OR gates, wherein the first input end is connected to one input terminal of the at least two input OR gates via a first resistor R1, each of the at least one second input end is connected to a corresponding input terminal of remaining input terminals of the at least two input OR gates via a diode, e.g., a diode D1 or D2, and output ends of the at least two input OR gates are used for outputting the second control signal used for controlling the turning-off of the power source, or the third control signal used for maintaining the turning-on of the power source.

In the present embodiment, the control circuit performs a logical OR operation on the first control signals collected by each of the input ends of the signal input circuit to generate corresponding control signals. The first resistor R1 is used for current limiting. The diode via which the second input end is connected needs to meet specific performance requirements, for example, the diode is required to have the characteristics of low forward voltage drop and high switching frequency. Optionally, the diode via which the second input end is connected may be a Schottky diode.

It should be noted that, when there is input impedance at the second input end, the first input end may not be connected to the first resistor R1.

In one possible implementation, the above-mentioned power source control circuit may further comprises: a switch circuit, connected to the output ends of the at least two input OR gates, and used for turning off or turning on the power source according to the control signals generated by the control circuit, wherein the switch circuit turns off the power source when the control circuit generates the second control signal, and the switch circuit turns on the power source when the control circuit generates the third control signal used for maintaining the turning-on of the power source.

In the present embodiment, when a fault occurs in the external device corresponding to the input end, the input end of the signal input circuit collects the first control signal which indicates that the external device is abnormal, the control circuit generates the second control signal used for controlling the turning-off of the power source according to the first control signal, and the switch circuit turns off the power source according to the second control signal generated by the control circuit. Accordingly, when no fault occurs in the external devices corresponding to all the input ends, all the input ends of the signal input circuit collect the first control signals which indicate that the external devices are normal, the control circuit generates, according to the first control signals, the third control signal used for maintaining the turning-on of the power source, and the switch circuit does not turn off the power source according to the third control signal generated by the control circuit.

In one possible implementation, referring to FIG. 3, the switch circuit comprises:
a second resistor R2 and a third resistor R3, wherein the second resistor R2 and the third resistor R3 are connected in series between the output ends of the at least two input OR gates and a ground terminal;
a first transistor Q1, wherein a base of the first transistor Q1 is connected to a connection point between the second resistor R2 and the third resistor R3, and an emitter of the first transistor Q1 is connected to the ground terminal;
a fourth resistor R4, a fifth resistor R5 and a second transistor Q2, wherein the fourth resistor R4 is connected between a collector of the first transistor Q1 and a base of the second transistor Q2, the fifth resistor R5 is connected between the fourth resistor R4 and an emitter of the second transistor Q2, and a connection point between the fifth resistor R5 and the emitter of the second transistor Q2 is connected to an output end of a boost circuit; and
a sixth resistor R6 and an MOS tube M1, wherein the sixth resistor R6 is connected between a control end (e.g., a gate) of the MOS tube M1 and a collector of the second transistor Q2, an input end (e.g., a drain) of the MOS tube M1 is connected to the power source VBATT, and an output end (e.g., a source) of the MOS tube M1 is connected to a voltage output end V_BATT-SWITCH terminal used for detecting the turning-on and turning-off of the power source.

In one possible implementation, the switch circuit further comprises a seventh resistor R7 and a Zener diode D4, wherein the seventh resistor R7 and the Zener diode D4 are connected in parallel between the output end (e.g., a source) of the MOS tube M1 and a connection point between the collector of the second transistor Q2 and the sixth resistor R6.

In one possible implementation, the switch circuit further comprises:
a ninth resistor R9 and a tenth resistor R10, wherein the ninth resistor R9 and the tenth resistor R10 are connected in series between the ground terminal and a connection point between the collector of the second transistor Q2 and the sixth resistor R6;
an eleventh resistor R11 and a third capacitor C3, wherein the eleventh resistor R11 and the third capacitor C3 are connected in series between the ground terminal and a connection point between the ninth resistor R9 and the tenth resistor R10; and
a gate voltage detection end BATT_SWITCH_GATE_ADC terminal, wherein the gate voltage detection end BATT_SWITCH_GATE_ADC terminal is connected to a connection point between the eleventh resistor R11 and the third capacitor C3.

The power source control circuit shown in FIG. 3 and the power source control circuit shown in FIG. 1 have same circuit structures with the same working principle. Therefore, due to space limitations, the same circuit structures of the power source control circuit shown in FIG. 3 and the power source control circuit shown in FIG. 1 will not be repeated in the present embodiment.

Still referring to FIG. 3, the signal input circuit of the power source control circuit comprises a total of 3 input ends: a HighLevel_Ctrl_CH1 terminal, a HighLevel_Ctrl_CH2 terminal and a HighLevel_Ctrl_CH13 terminal, wherein the HighLevel_Ctrl_CH1 terminal is connected to one end of the resistor R1, and the other end of the resistor R1 is connected to one end of the third resistor R3; the HighLevel_Ctrl_CH2 terminal is connected to a cathode of the diode D1, and an anode of the diode D1 is connected to the connection point between the resistor R1 and the third resistor R3; the HighLevel_Ctrl_CH13 terminal is connected to a cathode of the diode D2, and an anode of the diode D2 is connected to the connection point between the resistor R1 and the third resistor R3; the other end of the third resistor R3 is connected to one end of the second resistor R2; and the other end of the second resistor R2 is connected to the ground terminal.

The resistor R1 is a current limiting resistor, the resistor R2 is a bias resistor, and the diodes D1 and D2 are reverse Schottky diodes. A value of resistance of the resistor R1 is determined based on output impedance values of the HighLevel_Ctrl_CH2 terminal and the HighLevel_Ctrl_CH3 terminal, and output currents need to be limited below a specified limit. A value of resistance of the resistor R2 is determined according to saturated on and off conditions of the first transistor Q1, and the value of resistance of the resistor R2 is less than a value of resistance of the resistor R3.

When the first control signals collected by the HighLevel_Ctrl_CH1 terminal, the HighLevel_Ctrl_CH2 terminal and the HighLevel_Ctrl_CH3 terminal are all at a high level, e.g., 5 V, the first transistor Q1 is on under the action of the high level, and the second transistor Q2 is on under the action of the power source VBATT. Because a voltage difference value between the VCP terminal and the VBATT terminal is greater than an on voltage of the NMOS M1, the NMOS M1 is on. At this time, it is detected that an output voltage of the V _BATT-SWITCH terminal is 12 V, and a switch of the power source VBATT is turned on.

When the first control signal collected by at least one of the HighLevel_Ctrl_CH1 terminal, the HighLevel_Ctrl_CH2 terminal and the HighLevel_Ctrl_CH3 terminal changes from a high level to a low level, e.g., 0 V, the first transistor Q1 is off under the action of the low level, so that both the second transistor Q2 and the NMOS M1 are both off. At this time, it is detected that the output voltage of the V_BATT-SWITCH terminal is 0 V, and the switch of the power source VBATT is turned off.

It should be noted that the structures of the control circuit and the switch circuit in the present embodiment are basically the same as those of the first control circuit and the second control circuit in FIG. 1. However, it should be understood that the present invention has no specific restrictions to the specific structures of the control circuit and the switch circuit. Any circuit structure that can achieve the functions of the control circuit and the switch circuit respectively can be used to implement the control circuit and the switch circuit of the present embodiment.

FIG. 4 is a schematic diagram of on-off control of a power source switching from a high level to a low level in an embodiment of the present invention. Referring to FIG. 4, when the first control signal collected by the HighLevel_Ctrl_CH1 terminal switches from 5 V to 0 V, and the first control signals collected by the HighLevel_Ctrl_CH2 terminal and the HighLevel_Ctrl_CH3 terminal remain at 5 V, the output voltage of the V_BATT-SWITCH terminal is 0 V, and the switch of the power source VBATT is turned off.

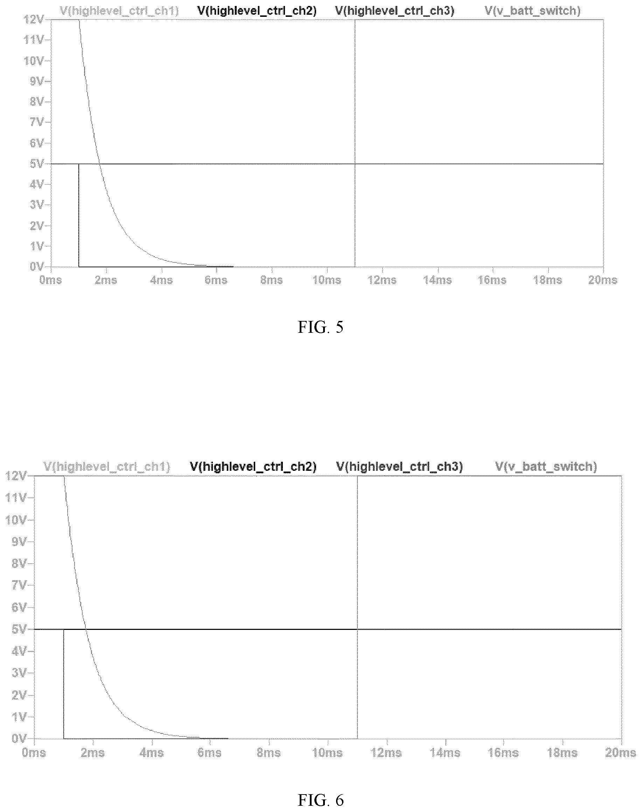

FIG. 5 is a schematic diagram of on-off control of a power source switching from a high level to a low level in an embodiment of the present invention. Referring to FIG. 5, when the first control signal collected by the HighLevel_Ctrl_CH2 terminal switches from 5 V to 0 V, and the first control signals collected by the HighLevel_Ctrl_CH1 terminal and the HighLevel_Ctrl_CH3 terminal remain at 5 V, the output voltage of the V _BATT-SWITCH terminal is 0 V, and the switch of the power source VBATT is turned off.

FIG. 6 is a schematic diagram of on-off control of a power source switching from a high level to a low level in an embodiment of the present invention. Referring to FIG. 6, when the first control signal collected by the HighLevel_Ctrl_CH3 terminal switches from 5 V to 0 V, and the first control signals collected by the HighLevel_Ctrl_CH1 terminal and the HighLevel_Ctrl_CH2 terminal remain at 5 V, the output voltage of the V _BATT-SWITCH terminal is 0 V, and the switch of the power source VBATT is turned off.

To sum up, the power source control circuit of the present embodiment can achieve multi-channel fault control, and the above-mentioned power source control circuit can be applied in a motor. During normal operation of the corresponding subsystems of the vehicle, the first control signals collected by the input ends comprised in the signal input circuit of the power source control circuit are all signals (for example, high levels, which are, for example, 5 V) which indicate that the corresponding subsystems are normal. When it is detected that a fault occurs in at least one of the subsystems, the first control signal collected by the input end corresponding the subsystem is a signal (for example, a low level, which is, for example, 0 V) which indicates that the corresponding subsystem is abnormal.

In addition, the power source control circuit of the present embodiment not only has a simple circuit design and a low material cost, but also enables convenient circuit transplantation and flexible configuration of corresponding structures of the power source control circuit.

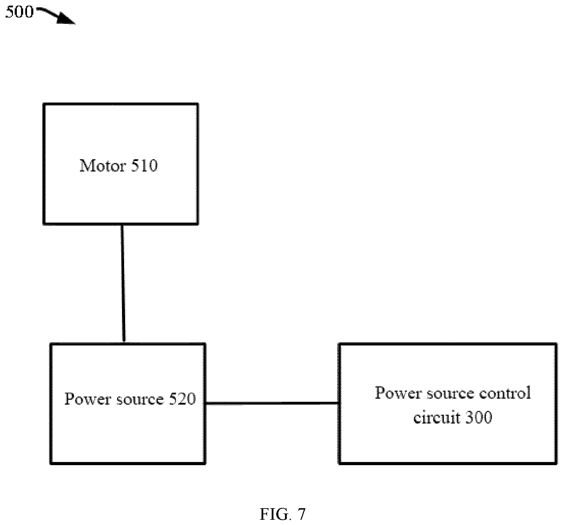

FIG. 7 is a structural diagram of a power steering system shown according to an exemplary embodiment. Referring to FIG. 7, the power steering system 500 may comprise a motor 510, a power source 520 and a power source control circuit 300, wherein the motor 510 is used for providing steering assisting power, and the motor 510 is also called a steering motor; the power source 520 is used for supplying electric power to the motor 510; and the power source control circuit 300 is used for controlling the turning-off or turning-on of the power source 520. Please refer to the preceding part of the text for relevant description of the power source control circuit 300, which will not be repeated here.

Hence, the power steering system which meets the high standard requirements of the vehicles, such as the commercial vehicles, for power steering can be provided.

The above is only specific embodiments of the present invention, but the protection scope of the present invention is not limited thereto, and any change or substitution that may be easily thought of by those skilled in the art within the technical scope disclosed by the present invention should be covered within the protection scope of the present invention. Therefore, the protection scope of the present invention shall be subject to the protection scope of the claims.

## Claims

1. A power source control circuit, **characterized in that** the power source control circuit comprises:
a signal input circuit, which comprises at least two input ends, wherein each of the at least two input ends is used for collecting a first control signal, which indicates whether an external device corresponding to the input end is abnormal; and
a control circuit, which is used for generating, according to the first control signals collected by each of the at least two input ends, a second control signal, which is used for controlling the turning-off of a power source.

2. The power source control circuit according to Claim 1, **characterized in that** the control circuit generates the second control signal when the first control signal collected by at least one of the at least two input ends indicates that the external device corresponding to the input end is abnormal.

3. The power source control circuit according to Claim 1, **characterized in that** the control circuit generates a third control signal used for maintaining the turning-on of the power source when the first control signals collected by each of the at least two input ends both indicate that the external devices corresponding to the input ends are normal.

4. The power source control circuit according to Claim 3, **characterized in that**
the first control signal indicates that the external device corresponding to the input end is abnormal when the first control signal collected by the input end satisfies a first predetermined condition; and the first control signal indicates that the external device corresponding to the input end is normal when the first control signal does not satisfy the first predetermined condition,
wherein the first predetermined condition comprises:
a level value to which the first control signal corresponds is lower than a predetermined level value; or
a level value to which the first control signal corresponds is within a preset level range.

5. The power source control circuit according to Claim 3, **characterized in that**
the first control signal indicates that the external device corresponding to the input end is abnormal when the first control signal collected by the input end satisfies a first predetermined condition; and the first control signal indicates that the external device corresponding to the input end is normal when the first control signal does not satisfy the first predetermined condition,
wherein the first predetermined condition comprises:
a level value to which the first control signal corresponds is higher than a predetermined level value; or
a level value to which the first control signal corresponds is within a preset level range.

6. The power source control circuit according to any one of Claims 1 to 5, **characterized in that**
the at least two input ends comprise a first input end and at least one second input end, and the control circuit comprises at least two input OR gates,
wherein the first input end is connected to one input terminal of the at least two input OR gates via a first resistor, each of the at least one second input end is connected to a corresponding input terminal of remaining input terminals of the at least two input OR gates via a diode, and output ends of the at least two input OR gates are used for outputting the second control signal used for controlling the turning-off of the power source, or the third control signal used for maintaining the turning-on of the power source.

7. The power source control circuit according to Claim 6, **characterized in that** the power source control circuit further comprises:
a switch circuit, connected to the output ends of the at least two input OR gates, and used for turning off or turning on the power source according to control signals generated by the control circuit,
wherein the switch circuit turns off the power source when the control circuit generates the second control signal, and
the switch circuit turns on the power source when the control circuit generates the third control signal used for maintaining the turning-on of the power source.

8. The power source control circuit according to Claim 7, **characterized in that** the switch circuit comprises:
a second resistor and a third resistor, wherein the second resistor and the third resistor are connected in series between the output ends of the at least two input OR gates and a ground terminal;
a first transistor, wherein a base of the first transistor is connected to a connection point between the second resistor and the third resistor, and an emitter of the first transistor is connected to the ground terminal;
a fourth resistor, a fifth resistor and a second transistor, wherein the fourth resistor is connected between a collector of the first transistor and a base of the second transistor, the fifth resistor is connected between the fourth resistor and an emitter of the second transistor, and a connection point between the fifth resistor and the emitter of the second transistor is connected to an output end of a boost circuit;
and a sixth resistor and an MOS tube, wherein the sixth resistor is connected between a control end of the MOS tube and a collector of the second transistor, an input end of the MOS tube is connected to the power source, and an output end of the MOS tube is connected to a voltage output end used for detecting the turning-on and turning-off of the power source.

9. The power source control circuit according to Claim 8, **characterized in that** the switch circuit further comprises a seventh resistor and a diode, wherein the seventh resistor and the diode are connected in parallel between the output end of the MOS tube and a connection point between the collector of the second transistor and the sixth resistor.

10. The power source control circuit according to Claim 8 or 9, **characterized in that** the switch circuit further comprises:
a ninth resistor and a tenth resistor, wherein the ninth resistor and the tenth resistor are connected in series between the ground terminal and the connection point between the collector of the second transistor and the sixth resistor;
an eleventh resistor and a third capacitor, wherein the eleventh resistor and the third capacitor are connected in series between the ground terminal and a connection point between the ninth resistor and the tenth resistor; and
a gate voltage detection end, wherein the gate voltage detection end is connected to a connection point between the eleventh resistor and the third capacitor.

11. A power steering system, **characterized in that** the power steering system comprises:
a motor, used for providing steering assisting power;
a power source, used for supplying electric power to the motor; and
a power source control circuit according to any one of Claims 1 to 10, used for controlling the turning-off or turning-on of the power source.
